# EUROPEAN PATENT APPLICATION

(11) **EP 4 636 429 A1**
(43) Date of publication of application: **22.10.2025**
(21) Application number: 24170147.3
(22) Date of filing: 15.04.2024
(51) Int. Cl.: G01R 33/565

(54) **COMPENSATION FOR ELECTROMAGNETIC INTERFERENCE SIGNALS IN MAGNETIC RESONANCE IMAGING**

(71) Applicant: Koninklijke Philips N.V., 5656 AG Eindhoven (NL)
(72) Inventor: VAN DEN BRINK, Johan Samuel, Eindhoven (NL)
(74) Representative: Philips Intellectual Property & Standards

(57) **Abstract**

Disclosed herein is a medical system (100) and a method of operating a medical system. The method comprises: executing (200) spoiling commands configured to adjust operation of a magnetic resonance imaging system such that magnetic resonance imaging signals during execution of pulse sequence commands (142) are spoiled, wherein the spoiling commands are configured such that sending of radio frequency transmissions are enabled during execution of the pulse sequence commands, wherein the pulse sequence commands are configured to control the magnetic resonance imaging system to acquire k-space data from an imaging zone using the magnetic resonance imaging antenna; acquiring (202) calibration k-space data (148) by controlling the magnetic resonance imaging system with the pulse sequence commands while the spoiling commands active; acquiring (204) reference radio frequency data (150) using at least one electromagnetic, EMI, detector, wherein the reference radio frequency data is acquired simultaneously with the calibration k-space data; and calibrating (206) an EMI signal removal module (144) using the reference radio frequency data and the calibration k-space data. In an embodiment the EMI signal removal module is configured to remove EMI signal from the acquired k-space data in response to receiving the detected spurious radiofrequency signals and the acquired k-space data as input. The system comprises a computational system configured to perform the method.

## Description

### TECHNICAL FIELD

The invention relates to magnetic resonance imaging, in particular to magnetic resonance imaging in the presence of spurious electromagnetic interference signals.

### BACKGROUND

A large static magnetic field is used by Magnetic Resonance Imaging (MRI) scanners to align the nuclear spins of atoms as part of the procedure for producing images within the body of a patient. This large static magnetic field is referred to as the B0 field or the main magnetic field.

During an MRI scan, Radio Frequency (RF) pulses generated by a transmitter coil cause perturbations to the local magnetic field, and RF signals emitted by the nuclear spins are detected by a receiver coil. These RF signals are used to construct the MRI images. However, electromagnetic interference (EMI) or spurious RF noise signals during the MRI scan can interfere with the measurement of the RF signals emitted by the nuclear spins. Typically, a large RF cage is built around the magnetic resonance imaging system to eliminate these spurious RF signals. A disadvantage to using such an RF cage is that it uses large amounts of metal such as copper and is expensive to build.

United States patent publication US10317502 B2 discloses a magnetic resonance imaging system for acquiring magnetic resonance data from an imaging zone. Execution of the instructions causes a processor controlling the MRI system to: acquire imaging magnetic resonance data with radio frequency excitation of the radio frequency system enabled; acquire noise radio frequency data using at least one RF noise detection coil, wherein the noise radio frequency data is acquired simultaneously with the imaging magnetic resonance data; acquire calibration magnetic resonance data with radio frequency excitation of the radio frequency system disabled; acquire reference radio frequency data using the at least one RF noise detection coil, wherein the reference radio frequency data is acquired simultaneously with the calibration magnetic resonance data; and calculate a noise calibration using the reference radio frequency data and the calibration magnetic resonance data.

### SUMMARY

The invention provides for a medical system, a method, and a computer program in the independent claims. Embodiments are given in the dependent claims.

In one aspect a medical system is disclosed. The medical system comprises a magnetic resonance imaging system with an imaging zone. The magnetic resonance imaging system comprises a magnet for generating a main magnetic field in the imaging zone. The magnetic resonance imaging system further comprises a radio-frequency system comprising a magnetic resonance antenna for sending and receiving radio-frequency transmissions within a predetermined bandwidth. The magnetic resonance antenna comprises at least one antenna element configured for receiving magnetic resonance signals from the imaging zone. The magnetic resonance imaging system further comprises at least one electromagnetic interference (EMI) detector for detecting radio-frequency signals within the predetermined bandwidth. The at least one EMI detector is positioned outside of the imaging zone.

The magnetic resonance imaging system further comprises a memory storing machine-executable instructions, pulse sequence commands, and an EMI signal removal module. The pulse sequence commands are configured to control the magnetic resonance imaging system to acquire k-space data from the imaging zone using the magnetic resonance imaging antenna. The EMI signal removal module is configured to remove EMI signals or spurious RF noise from the acquired k-space data in response to receiving the detected radio-frequency signals and the acquired k-space data as input. The magnetic resonance imaging system further comprises a computational system configured for controlling the magnetic resonance imaging system.

Execution of the machine-executable instructions causes the computational system to execute spoiling commands configured to adjust operation of the magnetic resonance imaging system such that the magnetic resonance imaging signals during execution of the pulse sequence commands are spoiled. The spoiling commands are configured such that the sending of the radio-frequency transmissions are enabled during execution of the pulse sequence commands. Execution of the machine-executable instructions further causes the computational system to acquire calibration k-space data by controlling the magnetic resonance imaging system with the pulse sequence commands with the spoiling commands active. Execution of the machine-executable instructions further causes the computational system to acquire reference radio-frequency data using the at least one EMI detector. The reference radio-frequency data is acquired simultaneously with the calibration k-space data. Execution of the machine-executable instructions further causes the computational system to calibrate the EMI signal removal module using the reference radio-frequency data and the calibration k-space data.

In another aspect a method of operating a medical system is disclosed. The medical system comprises a magnetic resonance imaging system with an imaging zone. The magnetic resonance imaging system comprises a magnet for generating a main magnetic field in the imaging zone. The magnetic resonance imaging system further comprises a radio-frequency system comprising a magnetic resonance antenna for sending and receiving radio-frequency transmissions within a predetermined bandwidth. The magnetic resonance antenna comprises at least one antenna element configured for receiving magnetic resonance signals from the imaging zone. The magnetic resonance imaging system further comprises at least one EMI detector for detecting radio-frequency signals within the predetermined bandwidth. The at least one EMI detector is positioned outside of the imaging zone.

The method comprises executing spoiling commands configured to adjust operation of the magnetic resonance imaging system such that the magnetic resonance imaging signals during execution of pulse sequence commands are spoiled. The spoiling commands are configured such that sending of the radio-frequency transmissions are enabled during execution of the pulse sequence commands. The pulse sequence commands are configured to control the magnetic resonance imaging system to acquire k-space data from the imaging zone using the magnetic resonance imaging antenna. The method further comprises acquiring calibration k-space data by controlling the magnetic resonance imaging system with the pulse sequence commands with the spoiling commands active. The method further comprises acquiring reference radio-frequency data using the at least one EMI detector. The reference radio-frequency data is acquired simultaneously with the calibration k-space data. The method further comprises calibrating an EMI signal removal module using the reference radio-frequency data and the calibration k-space data. The noise removal module is configured to remove EMI signals from the acquired k-space data in response to receiving the detected radio-frequency signals and the acquired k-space data as input.

In another aspect a computer program comprising machine-executable instructions and configured to control a computational system to perform an example of the method is disclosed.

### BRIEF DESCRIPTION OF THE DRAWINGS

In the following preferred embodiments of the invention will be described, by way of example only, and with reference to the drawings in which:
Fig. 1 illustrates an example of a medical system.
Fig. 2 shows a flow chart which illustrates a method according to the invention.
Fig. 3 shows a flow chart which illustrates a further method of using the medical system according to the invention.

### DESCRIPTION OF EMBODIMENTS

For the purposes of promoting and understanding the principles of the present disclosure, reference will now be made to the embodiments illustrated in the drawings, and specific language will be used to describe the same. It is nevertheless understood that no limitation to the scope of the disclosure is intended. Any alteration and further modifications to the described devices, systems, and methods, and any further application of the principles of the present disclosure are fully contemplated and included within the present disclosure as would normally occur to one skilled in the art to which the disclosure relates. In particular, it is fully contemplated that the features, components, and/or steps described with respect to one embodiment may be combined with the features, components, and/or steps described with respect to other embodiments of the present disclosure. For the sake of brevity, however, the numerous iterations of these combinations will not be described separately. Features described in relation to a system, may be implemented in a computer implemented method and/or in a computer program product, in a corresponding manner. Like numbered elements in these figures are either equivalent elements or perform the same function. Elements which have been discussed previously will not necessarily be discussed in later figures if the function is equivalent.

In an example, a medical system comprises a magnetic resonance imaging system with an imaging zone. An imaging zone encompasses a region where the magnetic field or main magnetic field is large enough and uniform enough to perform magnetic resonance imaging. The magnetic resonance imaging system comprises a magnet for generating a main magnet field in the imaging zone. The main magnetic field in many cases is also referred to as the B0 field. The magnetic resonance imaging system further comprises a radio-frequency system comprising a magnetic resonance antenna for sending and receiving radio-frequency transmissions within a predetermined bandwidth. The predetermined bandwidth may be the bandwidth where the magnetic resonance signals for the particular main magnetic field strength are located. The magnetic resonance antenna comprises at least one antenna element configured for receiving magnetic resonance signals from the imaging zone.

The magnetic resonance imaging system further comprises at least one electromagnetic interference (EMI) detector such as an RF or radio-frequency noise detection coil for detecting spurious EMI aor radio-frequency signals within the predetermined bandwidth. The spurious EMI signals may originate from an external source and therefore may cause spurious EMI signals in both the EMI detector and be measured by the radio frequency system of the magnetic resonance imaging system. The at least one EMI detector is positioned outside of the imaging zone. As the EMI detector is positioned outside of the imaging zone it may be able to pick up spurious EMI or RF signals with a larger amplitude than the magnetic resonance signals. In some cases, the EMI detector is a coil used to pick up RF signals within the predetermined bandwidth and in this case may be an RF noise detection coil.

In other cases, the EMI detector may be a broad band detector configured to additionally pick up or measure spurious EMI signals with frequencies greater than that specified by the predetermined bandwidth. The k-space data measured by the magnetic resonance imaging system is digitized. Spurious EMI signals above the frequency range specified by the predetermined bandwidth may still be detected by the radio frequency system and cause aliasing.

The magnetic resonance imaging system further comprises a memory storing machine-executable instructions, pulse sequence commands, and an EMI signal removal module. The pulse sequence commands are configured to control the magnetic resonance imaging system to acquire k-space data from the imaging zone using the magnetic resonance imaging antenna. The EMI signal removal module is configured to remove EMI signals from the acquired k-space data in response to receiving the detected radio-frequency signals and the acquired k-space data as input. In some examples the detected radio-frequency signals and the acquired k-space data are correlated in time.

The magnetic resonance imaging system further comprises a computational system configured for controlling the magnetic resonance imaging system. The execution of the machine-executable instructions causes the computational system to execute spoiling commands configured to adjust operation of the magnetic resonance imaging system such that the magnetic resonance imaging signals during execution of the pulse sequence commands are spoiled. Spoiled, as used herein, encompasses ruining or causing the amplitude of the magnetic resonance signals emitted to be lower than or comparable to the noise floor measured by the radio frequency system. As such, the magnetic resonance signals are unable or difficult to be distinguished from (thermal) noise measured by the radio frequency system. The spoiling commands are configured such that the sending of the radio-frequency transmissions are enabled during execution of the pulse sequence commands. This may encompass that the radio-frequency transmissions from the radio-frequency system have not been disabled. The spoiling of the magnetic resonance imaging signals are therefore not caused by a lack of radio-frequency transmissions from the radio-frequency system.

Execution of the machine-executable instructions further causes the computational system to acquire calibration k-space data by controlling the magnetic resonance imaging system with the pulse sequence commands with the spoiling commands active. The calibration k-space data is then measurements by the magnetic resonance imaging system that just comprise EMI signals and thermal noise and not the magnetic resonance signals. The effect of the spoiling commands is to kill or greatly reduce the magnetic resonance signals. Execution of the machine-executable instructions further causes the computational system to acquire reference radio-frequency data using the at least one EMI detector. The reference radio-frequency data is acquired simultaneously with the calibration k-space data. The calibration k-space data and the reference radio-frequency data may therefore be correlated in time. This data for example may be used to make a mapping between EMI signals measured in the EMI detector or detectors and the EMI signals present or measured in the k-space data. As the magnetic resonance signals had been killed by enabling the spoiling commands the reference radio-frequency data and the calibration k-space data both required identical EMI signals measured in two different radio-frequency systems. Execution of the machine-executable instructions further causes the computational system to calibrate the EMI signal removal module using the reference radio-frequency data and the calibration k-space data. The EMI signal removal module may for example be an artificial intelligence or machine learning based EMI signal removal module or it may use an algorithmic means of mapping EMI signals measured at the at least one EMI detector to measurements made using the radio-frequency system. For example, an algorithmic EMI signal removal module may be implemented as a transfer function.

This example may be beneficial because it may provide for an improved means of removing EMI signals from a magnetic resonance imaging signal. This for example may be particularly useful when using so called low or ultra low field magnetic resonance imaging systems that in particular do not have a radio-frequency shield.

The EMI signal removal module may be primarily for the removal of spurious EMI signal from the k-space data measured by the magnetic resonance imaging system. However, there are other types of noise measured such as thermal RF noise. In some examples, the EMI signal removal module may be configured to filter or remove the thermal noise from the k-space data. However thermal noise detected by the EMI detector would be uncorrelated to thermal noise measured by the radio frequency system, so the removal of thermal RF noise would be an additional functionality.

Having the radio-frequency transmissions enabled during the measurement of the reference radio-frequency data may be beneficial because the radio-frequency transmissions may affect the EMI signal levels or even the ambient noise levels measured in the k-space data. This method may for example provide superior results in comparison to when the radio-frequency system is disabled.

In another example execution of the machine-executable instructions further causes the computational system to acquire imaging k-space data by controlling the magnetic resonance imaging system with the pulse sequence commands. Execution of the machine-executable instructions further causes the computational system to acquire spurious EMI signal data using the at least one EMI detector. The spurious EMI signal data is acquired simultaneously with the imaging k-space data. They may be acquired such that they are timestamped or synchronized in time. Execution of the machine-executable instructions further causes the computational system to generate modified k-space data by inputting the imaging k-space and the spurious EMI signal data into the EMI signal removal module. This example may be beneficial because it may provide for a means of removing spurious EMI or RF signals from the acquired k-space data. This may provide for improved magnetic resonance imaging.

In another example, execution of the machine-executable instructions further causes the computational system to reconstruct a clinical magnetic resonance image from the modified k-space data. Likewise, this may provide for an improved means of magnetic resonance imaging.

In another example, execution of the machine-executable instructions further causes the deactivation of the spoiling commands during acquisition of the imaging magnetic resonance imaging data.

In another example, the EMI signal removal module is a neural network EMI signal removal module. The EMI signal removal module is calibrated by performing machine learning on the EMI signal removal module using the calibration k-space data and the reference radio-frequency data. In one example, the EMI signal removal module is pre-trained and the machine learning is transfer learning. For example the transfer learning provides a small amount of additional learning for the neural network such that it is modified to better model the calibration data.

In another example, the neural network EMI signal removal module is any one of the following: a convolutional neural network that may for example have at least four hidden layers, a recurrent neural network, a recurrent neural network comprising long short-term memory (LTSM) modules, a recursive neural network, a generative adversarial neural network, and a diffusion-based neural network.

In another example, the EMI signal removal module is an algorithmic EMI signal removal module. For example, the EMI signal removal module may correct electromagnetic interference (RMI) events by: calculating a temporally dependent EMI signal for each of the at least one antenna elements using the EMI signal calibration and the EMI signal event phase, EMI signal event frequency, and the EMI signal event amplitude, and subtracting the temporally dependent EMI signal from the imaging magnetic resonance data. This example may have the benefit of calculating a EMI signal on each of the at least one antenna elements in a straight forward and simple way.

In another example subtraction of the temporally dependent EMI signal from the imaging magnetic resonance data is performed in k-space. The measurements for magnetic resonance data measure the magnetic resonance imaging signal in k-space. The corrections can be performed directly in k-space.

In another example execution of the machine-executable instructions further causes the processor to divide the calibration k-space data into EMI signal temporal frames. In some examples the temporal frames may be for a time to acquire a line of k-space or for several lines of k-space. Execution of the instructions further causes the processor to divide the imaging k-space data into data temporal frames. There is a data temporal frame selected from the data temporal frames that corresponds in time to a EMI signal temporal frame that is selected from the EMI signal temporal frames. In other words, both the imaging magnetic resonance data and the EMI signal radio-frequency data are divided into short time intervals. Each of these short time intervals are referred to as temporal frames. The EMI signal radio-frequency data and the imaging magnetic resonance data are divided into these frames such that for each frame of the EMI signal radio-frequency data there is a corresponding frame of imaging magnetic resonance data. Execution of the instructions further causes the processor to calculate a short-time measured EMI signal spectrum for each of the EMI signal temporal frames. Execution of the instructions further cause the processor to calculate a short-time calculated EMI signal spectrum for each short-time measured EMI signal spectrum using the EMI signal calibration. Each of the EMI signal temporal frames for instance may have its Fourier transform performed so that a spectrum of the received radio-frequency data is created. This has an amplitude and frequency determination.

Execution of the instructions further cause the processor to calculate a short-time data spectrum (or short term Fourier transform) for each of the data temporal frames. In the same way the Fourier transform of each data temporal frame is created such that a radio-frequency spectrum is created. Next each of the short-time calculated EMI signal spectrum is binned into EMI signal frequency bins by execution of the instructions by the processor. Execution of the machine-executable instructions further cause the processor to bin each short-time data spectrum into data frequency bins. The binning of the short-time calculated EMI signal and the short-time data spectrum is performed using identical frequency bins. The data for both the EMI signal and the measurement has been broken into small timeframes then a spectrum has been calculated for each and then this is binned according to frequencies. Next execution of the machine-executable instructions further causes the processor to calculate corrected data frequency bins by subtracting the EMI signal frequency bins from the data frequency bins using identical frequency bins.

Execution of the machine executable instructions further cause the processor to re-synthesize the imaging magnetic resonance data using the corrected data frequency bins and an original phase spectrum of the imaging magnetic resonance data. This particular technique may be applied after the data has been acquired or it may also be performed on the fly.

In another example, the spoiling commands are configured to shift the sending of the radio-frequency transmission outside of the predetermined bandwidth. In this example the radio-frequency system is not disabled but instead, the frequency is shifted such that it no longer causes the magnetic resonance imaging signals to be generated. This may be advantageous because the radio-frequency system is still operational and may provide for a better calibration.

In another example, the spoiling commands are configured to modify the pulse sequence commands such that at least one spoiling gradient magnetic field is generated. This may for example cause a shimming magnetic field or a gradient magnetic field to be generated and to shift the magnetic resonance frequency such that when the pulse sequence commands are executed there are no or very few magnetic resonance signals generated.

In another example, the magnet is configured for adjusting the main magnetic field. The spoiling commands are configured to adjust the main magnetic field such that the magnetic resonance imaging resonance condition is not met. For example, if the magnet is generated using a resistive magnet, the magnetic field can be shifted up or down to spoil the magnetic resonance signals.

In another example, the magnetic resonance imaging system further comprises a magnetic field shimming system. The spoiling commands are configured to control the magnetic resonance field shimming system such that the magnetic resonance imaging signals are shifted outside of the predetermined bandwidth.

In another example, the main magnet field has a magnetic field strength with an imaging zone that is between 0.25 Tesla and 1 Tesla.

In another example, the main magnetic field has a magnetic field strength with the imaging zone within that is less than 0.25 Tesla and in other example less than 0.01 Tesla. These field strengths define magnetic resonance imaging systems which have ultra-low field strength. The implementation of the example may provide for a magnetic resonance imaging system that does not have an RF shield. This may for example make the resulting magnetic resonance imaging system more cost effective and easier to implement in a cost-effective way.

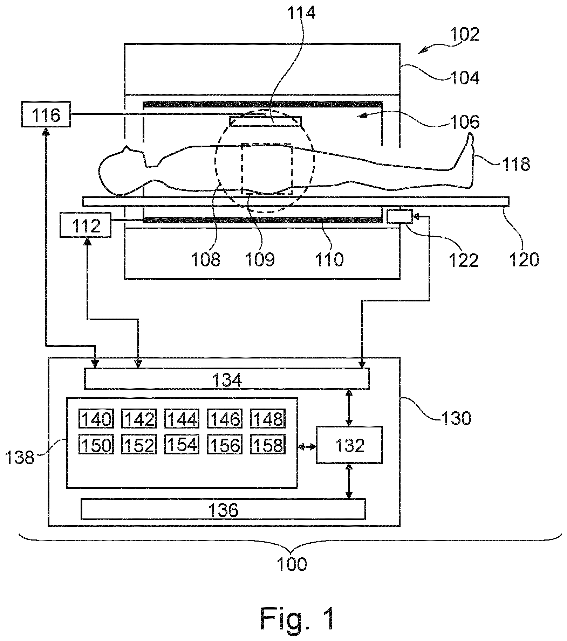

Fig. 1 illustrates an example of a medical system 100 that comprises a magnetic resonance imaging system 102 and a computer 130. The magnetic resonance imaging system 102 comprises a magnet 104. The magnet 104 is a superconducting cylindrical type magnet with a bore 106 through it. It is also possible to use both a split cylindrical magnet and a so-called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject. The arrangement of the two sections area is similar to that of a Helmholtz coil. Open magnets are popular because the subject is less confined. Inside the cryostat of the cylindrical magnet there is a collection of superconducting coils.

Within the bore 106 of the cylindrical magnet 104 there is an imaging zone 108 where the magnetic field is strong and uniform enough to perform magnetic resonance imaging. A field of view 109 is shown within the imaging zone 108. The k-space data are acquired for the field of view 109. The region of interest could be identical with the field of view 109 or it could be a sub volume of the field of view 109. A subject 118 is shown as being supported by a subject support 120 such that at least a portion of the subject 118 is within the imaging zone 108 and the field of view 109.

Within the bore 106 of the magnet there is also a set of magnetic field gradient coils 110 which is used for the acquisition of measured k-space data to spatially encode magnetic spins within the imaging zone 108 of the magnet 104. The magnetic field gradient coils 110 are connected to a magnetic field gradient coil power supply 112. The magnetic field gradient coils 110 are intended to be representative. Typically, magnetic field gradient coils 110 contain three separate sets of coils for spatial encoding in three orthogonal spatial directions. A magnetic field gradient power supply supplies current to the magnetic field gradient coils. The current supplied to the magnetic field gradient coils 110 is controlled as a function of time and may be ramped or pulsed.

Adjacent to the imaging zone 108 is a radio frequency coil 114 for manipulating the orientations of magnetic spins within the imaging zone 108 and for receiving radio transmissions from spins also within the imaging zone 108. The radio frequency antenna may contain multiple coil elements. The radio frequency antenna may also be referred to as a channel or antenna. The radio frequency coil 114 is connected to a radio frequency transceiver 116. The radio frequency coil 114 and radio frequency transceiver 116 may be replaced by separate transmit and receive coils and a separate transmitter and receiver. It is understood that the radio frequency coil 114 and the radio frequency transceiver 116 are representative. The radio frequency coil 114 is intended to also represent a dedicated transmit antenna and a dedicated receive antenna. Likewise, the transceiver 116 may also represent a separate transmitter and receiver. The radio frequency coil 114 may also have multiple receive/transmit elements and the radio frequency transceiver 116 may have multiple receive/transmit channels. The transceiver 116 and the gradient controller 112 are shown as being connected to the hardware interface 134 of the computer system 132.

The magnetic resonance imaging system 102 is shown as further comprising an EMI detector 122 that is located outside of the imaging zone 108. Both the radio-frequency coil 114 and the EMI detector 122 would likely pick up any spurious EMI or radio-frequency signals. Spurious EMI or radio-frequency signals can often times be eliminated by providing an RF shield around the magnetic resonance imaging system 102. In lower cost systems such as low field or ultra low field magnetic resonance imaging systems, this may be too expensive or may not be practical in some installations. The EMI detector 122 may provide a means of removing spurious signals from recorded k-space data. This may for example improve the quality of magnetic resonance images and also enable a magnetic resonance imaging system to be constructed more inexpensively.

The transceiver 116, the magnetic field gradient coil power supply 112 and the EMI detector 122 are shown as being connected to a hardware interface of computer 130. The computer 130 is further shown as comprising a computational system 132. The computer 130 and the computational system 132 may be one or more computer systems or computational systems located at one or more locations. The hardware interface 134 may enable the computational system 132 to communicate with and to control other components of the medical system 100. The computational system 132 is further shown as being in communication with an optional user interface 136 and a memory 138. The memory 138 is intended to represent different types of memory which may be accessible to the computational system 132. The memory in some embodiments may be based on or may rely on cloud-based data stored in logical pools across disparate, commodity storage servers located on premises or in a data center managed by a third-party cloud provider. Accordingly, the memory as schematically depicted in Fig. 1 is just for illustration purposes. Therefore, any or all components comprised in memory may be cloud-based.

The memory 138 is shown as containing machine-executable instructions 140. The machine-executable instructions 140 enable the computational system 132 to perform various data and image processing tasks as well as to control the magnetic resonance imaging system 102. The memory 138 is further shown as containing an EMI signal removal module 144 configured to remove EMI signals from acquired k-space data in response to receiving detected radio-frequency signals and the acquired k-space data as input. The memory 138 is further shown as containing spoiling commands 146. The spoiling commands 146 are commands which are used to control one or more components of the magnetic resonance imaging system 102 to alter its operation so that magnetic resonance signals are no longer generated when the pulse sequence commands 142 are executed. This may for example be done in a variety of ways by changing the frequency of the radio-frequency signals or by altering the magnetic field. For example a shim of the magnet could be controlled as well as changing the main magnetic field or even modifying the gradient magnetic field produced by the gradient coil system 112.

The memory 138 is shown as containing calibration k-space data 148 that was acquired by executing the pulse sequence commands 142 when the spoiling commands 146 were active. The memory 138 is further shown as containing reference radio-frequency data 150 that was acquired and is synchronized with the calibration k-space data 148. Spurious signals that occur in the reference radio-frequency data 150 would likely also occur at the same time in the calibration k-space data 148. The reference radio-frequency data 150 and the calibration k-space data 148 are used to calibrate the EMI signal removal module 144.

The memory 138 is optionally shown as containing imaging k-space data 152. The memory 138 is also shown as containing spurious EMI signal data 154 also. The memory 138 is further shown as containing modified k-space data 156 that was generated by inputting the imaging k-space data 152 and the spurious EMI signal data 154 into the EMI signal removal module 144. The modified k-space data 156 then has the spurious EMI or radio-frequency signals are reduced or eliminated. The memory 138 is further shown as containing a clinical magnetic resonance image 158 that was reconstructed from the modified k-space data 156.

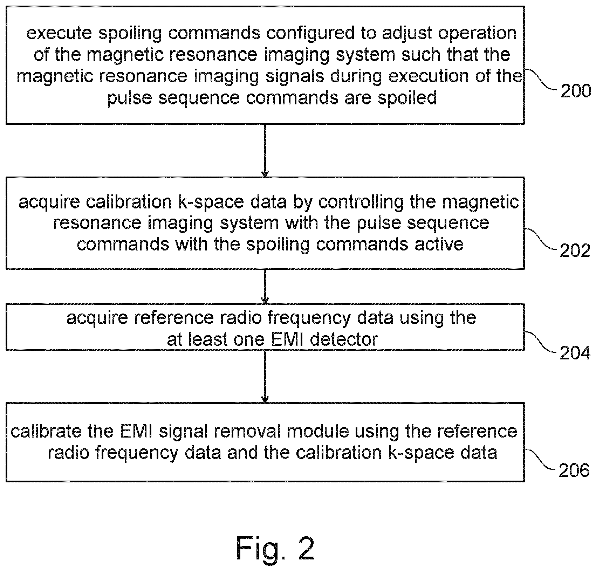

Fig. 2 shows a flowchart which illustrates a method of operating a medical system, such as for example the medical system 100 of Fig. 1. In step 200 the spoiling commands 146 are executed. The spoiling commands 146 are configured to adjust operation of the magnetic resonance imaging system such that the magnetic resonance imaging signals during execution of the pulse sequence commands are spoiled. In step 202, the calibration k-space data is acquired by controlling the magnetic resonance imaging system 102 with the pulse sequence commands 142 when the spoiling commands 146 are active. Step 204 is performed at the same time as step 202. In step 204, the reference radio-frequency data 150 is acquired using the at least one EMI detector 122. In step 206, the EMI signal removal module 144 is calibrated using the reference radio-frequency data 150 and the calibration k-space data 148.

Calibration may for example be accomplished in several different ways. If it is a machine learning module then the reference radio-frequency data 150 and the calibration k-space data 148 may be used as training data. Other instances and a model may be used to model the spurious EMI signals in the k-space data as a function of the input radio-frequency data using the data just collected 148, 150.

The calibration may be used in a variety of ways also. The calibration may be performed immediately before or after the imaging k-space data 152 is acquired. In some cases the calibrated EMI signal removal module may be stored or retained in the memory 138 for later use. For example, it could be recalled for use with the same subject during similar imaging procedures or even for use with other subjects undergoing similar imaging procedures.

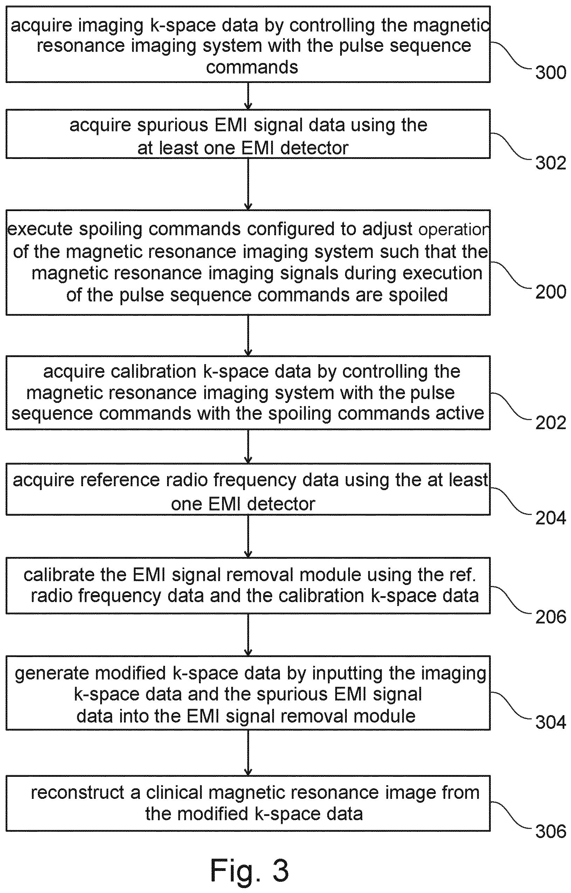

Fig. 3 shows another flowchart which illustrates a method of operating a medical system, such as the medical system 100 of Fig. 1. In this example, the imaging k-space data 152 is acquired before the calibration k-space data 148. In other examples, the calibration k-space data 148 could be acquired first.

The method begins with step 300. In step 300 the imaging k-space data 152 is acquired by controlling the magnetic resonance imaging system with the pulse sequence commands 142. Step 302 is performed at the same time as step 300. In step 302, the spurious EMI signal data 154 is acquired using the at least one EMI detector 122. Steps 200, 202, 204, and 206 are then performed. In some examples, steps 200, 202, and 204 are performed before steps 300 and 302.

After steps 200-206 are performed, in step 304 the modified k-space data 156 is generated by inputting the imaging k-space data 152 and the spurious EMI signal data 154 into the EMI signal removal module 144. In step 306, the clinical magnetic resonance image 158 is reconstructed from the modified k-space data 156.

It is understood that one or more of the aforementioned examples or embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A `computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

`Computer memory' or 'memory' is an example of a computer-readable storage medium. Computer memory is any memory which is directly accessible to a computational system. `Computer storage' or 'storage' is a further example of a computer-readable storage medium. Computer storage is any non-volatile computer-readable storage medium. In some embodiments computer storage may also be computer memory or vice versa.

A `computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a computational system of a general-purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A `user interface' as used herein is an interface which allows a user or operator to interact with a computer or computer system. A `user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A `hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or `display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen,
Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

## Claims

1. A medical system (100) comprising:
- a magnetic resonance imaging system (102) having an imaging zone (108), wherein the magnetic resonance imaging system comprises:
- a magnet (104) for generating a main magnetic field in the imaging zone;
- a radio frequency system (116) comprising a magnetic resonance antenna (114) for sending and receiving radio frequency transmissions within a predetermined bandwidth, wherein the magnetic resonance antenna comprises at least one antenna element configured for receiving magnetic resonance signals from the imaging zone;
- at least one electromagnetic interference, EMI, detector (122) for detecting radio-frequency signals within the predetermined bandwidth, wherein the at least one EMI detector is positioned outside of the imaging zone;
- an EMI signal removal module (144);
- a computational system (132) for controlling the magnetic resonance imaging system and configured to:
- execute (200) spoiling commands (146) configured to adjust operation of the magnetic resonance imaging system such that the magnetic resonance imaging signals during execution of pulse sequence commands (142) are spoiled, wherein the spoiling commands are configured such that sending of the radio frequency transmissions are enabled during execution of the pulse sequence commands;
- acquire (202) calibration k-space data (148) by controlling the magnetic resonance imaging system with the pulse sequence commands while the spoiling commands active;
- acquire (204) reference radio frequency data (150) using the at least one EMI detector, wherein the reference radio frequency data is acquired simultaneously with the calibration k-space data; and
- calibrate (206) the EMI signal removal module using the reference radio frequency data and the calibration k-space data.

2. The medical system of claim 1, wherein the computational system is further configured to:
- acquire (300) imaging k-space data (152) by controlling the magnetic resonance imaging system with the pulse sequence commands;
- acquire (302) spurious EMI signal data (154) using the at least one EMI detector, wherein the EMI signal data is acquired simultaneously with the imaging k-space data;
- generate (304) modified k-space data by inputting the imaging k-space data and the spurious EMI signal data into the EMI signal removal module.

3. The medical system of claim 2, wherein the computational system is further configured to reconstruct (306) a clinical magnetic resonance image (158) from the modified k-space data.

4. The medical system of claim 2 or 3, wherein the computational system is further configured to deactivate the spoiling commands during acquisition of the imaging k-space data.

5. The medical system of claim of any one of the preceding claims, wherein the EMI signal removal module is a neural network EMI signal removal module, and wherein the EMI signal removal module is calibrated by performing transfer learning on the EMI signal removal module using the calibration k-space data and the reference radio frequency data.

6. The medical system of claim 5, wherein the neural network EMI signal removal module is any one of the following: a convolutional neural network with at least four hidden layers, a recurrent neural network, a recurrent neural network comprising long short-term memory, LTSM, modules, a recursive neural network, a generative adversarial neural network, and a diffusion based neural network.

7. The medical system of any one of claims 1 to 4, wherein the EMI signal removal module is an algorithmic EMI signal removal module.

8. The medical system of any one of the claims, wherein the spoiling commands are configured to shift the sending of the radio-frequency transmissions outside of the predetermined bandwidth.

9. The medical system of any one of the preceding claims, wherein the spoiling commands are configured to modify the pulse sequence commands such that at least one spoiling gradient magnetic field is generated.

10. The medical system of any one of the preceding claims, wherein the magnet is configured for adjusting the main magnetic field, wherein the spoiling commands are configured to adjust the main magnetic field such that the magnetic resonance imaging resonance condition is not met.

11. The medical system of any one of the preceding claims, wherein the magnetic resonance imaging system further comprises a magnetic field shimming system, wherein the spoiling commands are configured to control the magnetic field shimming system such that the magnetic resonance imaging signals are shifted outside of the predetermined bandwidth.

12. The medical system of any one of the preceding claims, wherein the main magnetic field has a magnetic field strength with the imaging zone that is any one of the following: less than 1 Tesla, less than 0.25 Tesla, and optionally less than 0.01 Tesla.

13. A method of operating a magnetic resonance imaging system (102), comprising:
- executing (200) spoiling commands configured to adjust operation of the magnetic resonance imaging system such that magnetic resonance imaging signals during execution of pulse sequence commands (142) are spoiled, wherein the spoiling commands are configured such that sending of radio frequency transmissions are enabled during execution of the pulse sequence commands, wherein the pulse sequence commands are configured to control the magnetic resonance imaging system to acquire k-space data from an imaging zone using the magnetic resonance imaging antenna;
- acquiring (202) calibration k-space data (148) by controlling the magnetic resonance imaging system with the pulse sequence commands while the spoiling commands active;
- acquiring (204) reference radio frequency data (150) using at least one electromagnetic, EMI, detector, wherein the reference radio frequency data is acquired simultaneously with the calibration k-space data; and
- calibrating (206) an EMI signal removal module (144) using the reference radio frequency data and the calibration k-space data.

14. The method of claim 13, further comprising:
- acquiring (300) imaging k-space data (152) by controlling the magnetic resonance imaging system with the pulse sequence commands;
- acquiring (302) spurious EMI signal data (154) using the at least one EMI detector, wherein the EMI signal data is acquired simultaneously with the imaging k-space data;
- generating (304) modified k-space data by inputting the imaging k-space data and the spurious EMI signal data into the EMI signal removal module.

15. A computer program comprising machine executable instructions, wherein execution of the machine executable instructions causes a computational system to perform a method according to claim 13 or 14.
